# EUROPEAN PATENT APPLICATION

(11) **EP 4 773 180 A1**
(43) Date of publication of application: **08.07.2026**
(21) Application number: 24859297.4
(22) Date of filing: 30.07.2024
(51) Int. Cl.: H01L 21/683

(54) **SEMICONDUCTOR MANUFACTURING DEVICE AND SUPPORT MECHANISM**

(30) Priority: 31.08.2023 JP 2023141612
(71) Applicant: Teikoku Taping System Co., Ltd., Tokai-shi, Aichi 477-0032 (JP)
(72) Inventor: KATSUSHIMA, Yoshinori, Tokai-shi, Aichi 477-0032 (JP)
(74) Representative: Epping - Hermann - Fischer
(86) International application number: PCT/JP2024/027155
(87) International publication number: WO 2025/047255

(57) **Abstract**

A film attaching device (1) includes: a table (2) configured to support a semiconductor wafer (W); a pressing roller (20) configured to press a photoresist film (6) to be attached to the semiconductor wafer (W) placed on the table (2); an outer peripheral support member (5) provided on an outer peripheral side of the table (2) and arranged so as to receive a pressing force from the pressing roller (20) when the pressing roller (20) presses the photoresist film (6); and a support mechanism (50) configured to support the outer peripheral support member (5) at at least three positions spaced apart from each other and independently adjust a height of the outer peripheral support member (5) at the at least three positions.

## Description

### TECHNICAL FIELD

The present disclosure relates to a semiconductor manufacturing device and a support mechanism.

### BACKGROUND ART

A film attaching device is known in the related art, which includes: a table configured to support a semiconductor wafer; a pressing member configured to press a film onto the semiconductor wafer placed on the table; and a bumper member configured to serve as an outer peripheral support member provided on an outer peripheral side of the table and arranged so as to receive a pressing force from the pressing member when the pressing member presses the film (see Patent Document 1).

### CITATION LIST

### PATENT LITERATURE

Patent Document 1: Japanese Patent No. 4376250

### SUMMARY OF THE INVENTION

### PROBLEM TO BE SOLVED BY THE INVENTION

The above-described device is configured such that the bumper member is raised and lowered by screwing engagement between a pair of female and male screws. Thus, in the device, when an inclination occurs on an upper surface of the bumper member, the inclination may possibly not be corrected. This is because the presence or absence of the inclination, or the degree of the inclination, of the upper surface of the bumper member when the bumper member is raised and lowered by the screwing engagement between the pair of female and male screws greatly depends on the machining accuracy of the pair of female and male screws.

Therefore, it is desirable to provide a semiconductor manufacturing device capable of correcting the inclination of the upper surface of an outer peripheral support member such as the bumper member.

### MEANS FOR SOLVING THE PROBLEM

A semiconductor manufacturing device according to an embodiment of the present invention includes: a table configured to support a semiconductor wafer; a pressing member configured to press a film to be attached to the semiconductor wafer placed on the table; an outer peripheral support member provided on an outer peripheral side of the table and arranged so as to receive a pressing force from the pressing member when the pressing member presses the film; and a support mechanism configured to support the outer peripheral support member at at least three positions spaced apart from each other and independently adjust a height of the outer peripheral support member at the at least three positions.

### ADVANTAGEOUS EFFECTS OF THE INVENTION

The above-described semiconductor manufacturing device is capable of correcting the inclination of the upper surface of the outer peripheral support member.

### BRIEF DESCRIPTION OF THE DRAWINGS

[FIG. 1] FIG. 1 is a side view of a film attaching device according to an embodiment of the present disclosure.
[FIG. 2] FIG. 2 is a diagram illustrating functions of a controller mounted on the film attaching device.
[FIG. 3] FIG. 3 is a diagram illustrating a pressing pattern.
[FIG. 4] FIG. 4 is a side view of the film attaching device when a moving unit is moved toward a left end.
[FIG. 5] FIG. 5 is a side view of the film attaching device when the moving unit is moved toward a right end.
[FIG. 6] FIG. 6 is a view showing an example of a film to be trimmed by a cutting unit.
[FIG. 7] FIG. 7 is a view showing a configuration example of a hollow structure.
[FIG. 8] FIG. 8 is a view showing the configuration example of the hollow structure.
[FIG. 9] FIG. 9 is a view showing a configuration example of a raising and lowering support mechanism.
[FIG. 10] FIG. 10 is a right side view of an outer peripheral support member and the raising and lowering support mechanism.
[FIG. 11] FIG. 11 is a bottom view of the outer peripheral support member and the raising and lowering support mechanism.
[FIG. 12] FIG. 12 is a top view of a semiconductor wafer placed on a table and the outer peripheral support member.
[FIG. 13] FIG. 13 is a view showing another configuration example of the raising and lowering support mechanism.

### DESCRIPTION OF THE EMBODIMENTS

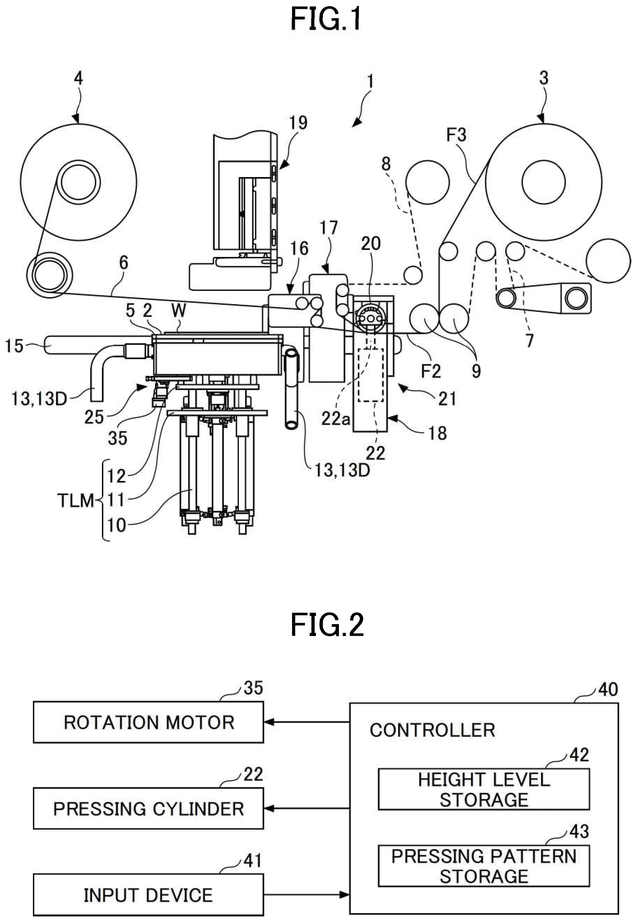

First, a film attaching device 1, which is an example of a semiconductor manufacturing device according to an embodiment of the present disclosure, will be described with reference to FIG. 1. FIG. 1 is a schematic view of the film attaching device 1.

The film attaching device 1 is used to attach a film, such as a photoresist film 6, to a semiconductor wafer W, and includes a table 2 that is circular in plan view and configured to support a semiconductor wafer W that is circular in plan view. A film supply unit 3 and a winding unit 4 are arranged at a predetermined distance from each other at positions obliquely above the table 2. A three-layer film F3 is supplied from the film supply unit 3. In the illustrated example, the three-layer film F3 is formed by laminating a carrier film 7 on one surface of the photoresist film 6 having heat-sensitive adhesiveness and a reinforcing film 8 on the other surface of the photoresist film 6. The carrier film 7 is detached from the three-layer film F3 by a pinch roller 9 to form a two-layer film F2. Then, the two-layer film F2 is pressed onto and attached to the surface of the semiconductor wafer W. Thereafter, the reinforcing film 8 is detached from the two-layer film F2 by horizontal movement of a moving unit described later.

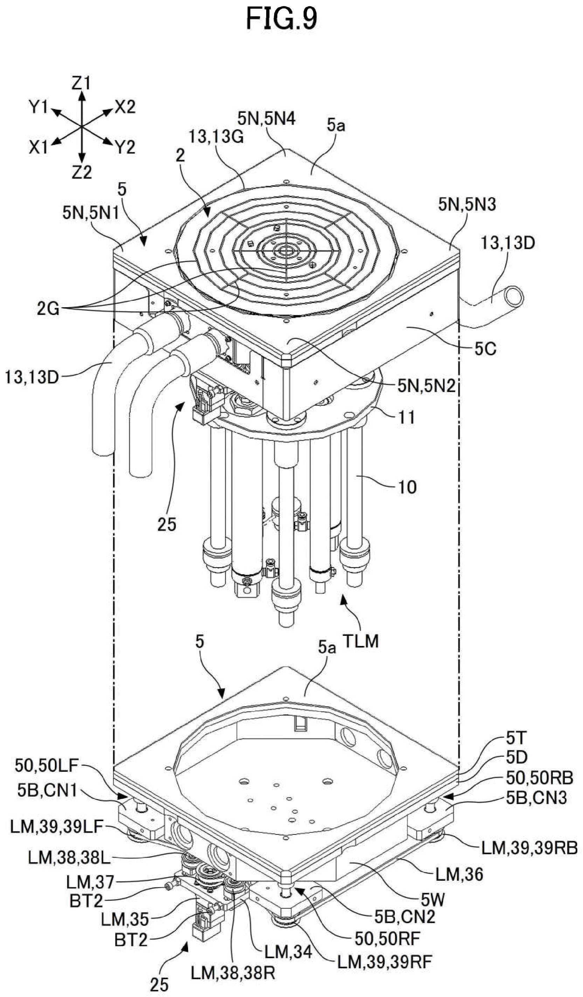

The table 2 is configured to be raised and lowered by a table raising and lowering mechanism TLM including slide rods 10, a base plate 11, and a support 12. Specifically, the table 2 is fixed, via the base plate 11 and the support 12, to upper ends of four slide rods 10 that are supported by a frame (not shown) so as to be vertically movable. The slide rods 10 are driven upward and downward by a driving force of a drive source (not shown), such as an air cylinder, to raise and lower the table 2. The table 2 has a portion of a suction passage formed therein, one end of the suction passage being open to a placement surface (a wafer-supporting surface) of the table 2 and the other end being connected to a suction source (not shown), such as a pump. In the illustrated example, the suction passage has grooves 2G (see FIG. 9) formed in the placement surface (the upper surface) of the table 2, and a plurality of through-holes formed in the grooves 2G and extending through the table 2 in a vertical direction. Accordingly, the semiconductor wafer W is held on the table 2 by a suction force generated by the suction source.

As shown in FIG. 1, a slide shaft 15 extending in a horizontal direction (a direction perpendicular to a rotation axis of the pinch roller 9) is arranged on one side of the table 2 in a direction parallel to the rotation axis of the pinch roller 9. The moving unit including a first moving unit 16, a second moving unit 17, and a third moving unit 18 is supported on the slide shaft 15 so as to be slidable. The moving unit is configured to be horizontally moved by a driving force of a drive source (not shown) such as an air cylinder. A cutting unit 19 serving as a filmcutting mechanism for trimming the photoresist film 6 attached to the semiconductor wafer W with a laser is provided above the table 2 so as to be movable horizontally. The cutting unit 19 may include a blade for cutting the film instead of the device that emits a laser for cutting the film.

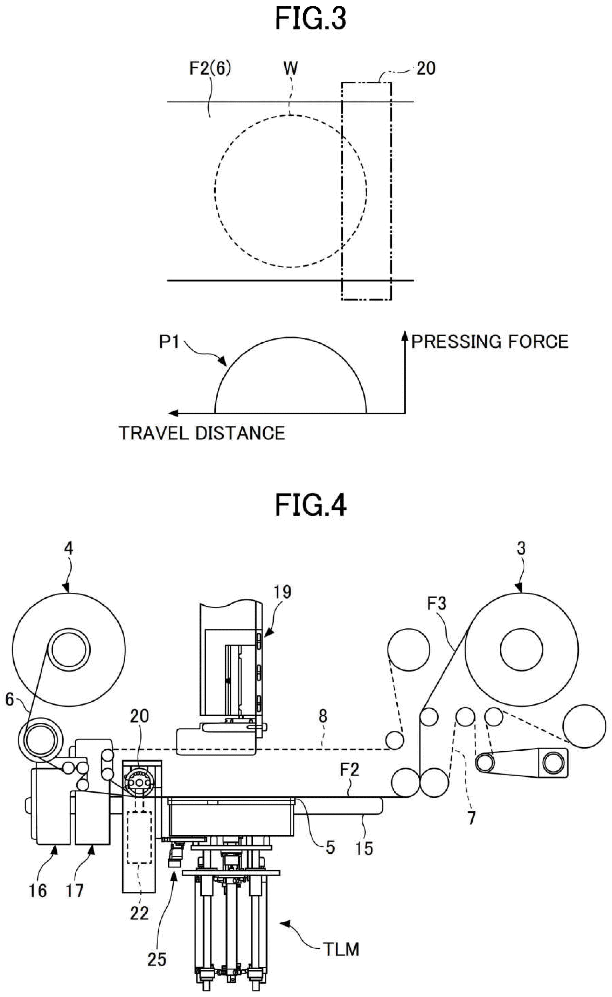

The third moving unit 18 has a pressing roller 20 for pressing the photoresist film 6 onto the surface of the semiconductor wafer W on the table 2. The pressing roller 20 is an example of a pressing member, and at least a roller surface of the pressing roller 20 is formed of an elastic material such as rubber. The film attaching device 1 can align the two-layer film F2 with the surface of the semiconductor wafer W on the table 2 by moving the moving unit (see FIG. 1) located on one end side (right end side) of the slide shaft 15 toward the other end side (left end side) of the slide shaft 15 as shown in FIG. 4. The film attaching device 1 can attach the two-layer film F2 to the surface of the semiconductor wafer W by pressing the two-layer film F2 with the pressing roller 20.

The pressing roller 20 may be configured such that a pressing force thereof is adjusted by a pressing-force adjustment mechanism 21 depending on a pressing area of the semiconductor wafer W (i.e., a contact area between the pressing roller 20 and the semiconductor wafer W). In the illustrated example, the pressing-force adjustment mechanism 21 includes a pressing cylinder 22 having a piston rod 22a. A tip of the piston rod 22a is connected to a support member (not shown) configured to support the pressing roller 20 so as to be rotatable. The pressing cylinder 22 is an example of a pressing drive source and is configured to finely adjust the protruding and retracting operation of the piston rod 22a by supplying a fluid in an amount corresponding to the pressing area of the semiconductor wafer W from a fluid supply source such as a pump.

An outer peripheral support member 5 that is rectangular and annular is provided along the outer periphery of the table 2. The outer peripheral support member 5 is also referred to as a bumper member, and has an upper surface 5a that functions as a contact surface with which the pressing roller 20 comes into contact when pressing the photoresist film 6. The outer peripheral support member 5 is supported by a raising and lowering support mechanism 25 including a rotation motor 35 so as to be capable of being raised and lowered, and is configured such that the heights of four corners of the outer peripheral support member 5 are independently adjusted. In the illustrated example, the outer peripheral support member 5 is also referred to as a digital bumper because a height level of the outer peripheral support member 5 is adjusted by computer control. A portion of an exhaust passage is formed between the table 2 and the outer peripheral support member 5. One end of the exhaust passage is open to the placement surface, and the other end is connected to an exhaust device (not shown) such as an exhaust fan. In the illustrated example, the exhaust passage discharges smoke and the like generated when the film is cut by the cutting unit 19 using a laser, and includes a gap 13G (see FIG. 9), which is annular, between the table 2 and the outer peripheral support member 5, and pipes 13D (see FIG. 9) connected to a side surface of the outer peripheral support member 5. That is, in the illustrated example, the exhaust device and the exhaust passage form an air knife for removing unnecessary matter generated when the film is cut by the cutting unit 19. With this configuration, air flowing through the exhaust passage can rapidly cool a cut surface of the film resulting from cutting by the cutting unit 19 and achieve a clean cut surface of the film without burrs or the like.

Next, functions of the film attaching device 1 will be described with reference to FIG. 2. FIG. 2 is a block diagram illustrating the functions of a controller 40 mounted on the film attaching device 1. Specifically, the film attaching device 1 includes the controller 40 configured to control the functions related to the attachment of the film. The rotation motor 35, the pressing cylinder 22, and an input device 41 are connected to the controller 40. The input device 41 is, for example, a keyboard, a mouse, or a touch-operated device. The controller 40 includes a height level storage 42 configured to store a plurality of height levels of the outer peripheral support member 5 predetermined in accordance with the shape, size, or the like of the semiconductor wafer W, and a pressing pattern storage 43 configured to store a plurality of pressing patterns predetermined in accordance with the shape, size, or the like of the semiconductor wafer W.

In the illustrated example, the controller 40 first determines whether or not a height level switching command is input from the input device 41. When a height level switching command is input from the input device 41, the controller 40 selects a specific height level corresponding to the switching command from among the plurality of height levels stored in the height level storage 42. Thereafter, the controller 40 drives the rotation motor 35 so that the height reaches the selected height level.

The controller 40 also determines whether or not a pressing pattern switching command is input from the input device 41. When a pressing pattern switching command is input from the input device 41, the controller 40 selects a specific pressing pattern corresponding to the switching command from among the plurality of pressing patterns stored in the pressing pattern storage 43. Thereafter, the controller 40 drives the pressing cylinder 22 to apply the selected pressing pattern.

As described above, in the film attaching device 1, when a height level switching command corresponding to the shape of the semiconductor wafer W to be used is input to the controller 40, the controller 40 selects a specific height level corresponding to the switching command, and the rotation motor 35, which is a drive source for the raising and lowering support mechanism 25, is driven. As a result, the outer peripheral support member 5 is raised and lowered, and the outer peripheral support member 5 is positioned at the specific height level.

Moreover, in the film attaching device 1, when a pressing pattern switching command corresponding to the shape of the semiconductor wafer W to be used is input to the controller 40, the controller 40 selects a specific pressing pattern corresponding to the switching command. In the illustrated example, as shown in FIG. 3, a pressing pattern P1 corresponding to the semiconductor wafer W that is circular in plan view is selected.

Next, a film attaching process will be described. First, as shown in FIG. 4, the film attaching device 1 causes the moving unit (the first moving unit 16, the second moving unit 17, and the third moving unit 18) that is located on one end (right end) of the slide shaft 15 to simultaneously travel and move toward the other end (left end) of the slide shaft 15. Then, the two-layer film F2 supplied from the film supply unit 3 is aligned with the surface of the semiconductor wafer W on the table 2, and the two-layer film F2 is pressed by the pressing roller 20 of the third moving unit 18 with the pressing pattern P1 (see FIG. 3) and attached to the surface of the semiconductor wafer W. When the two-layer film F2 is pressed, the pressing roller 20 rolls, in a state of being in contact with the upper surface 5a, on the upper surface 5a of the outer peripheral support member 5 whose height level is adjusted. Note that the upper surface 5a of the outer peripheral support member 5 may be coated with Teflon (trademark) or Topical (trademark) so that the attached film is easily detached.

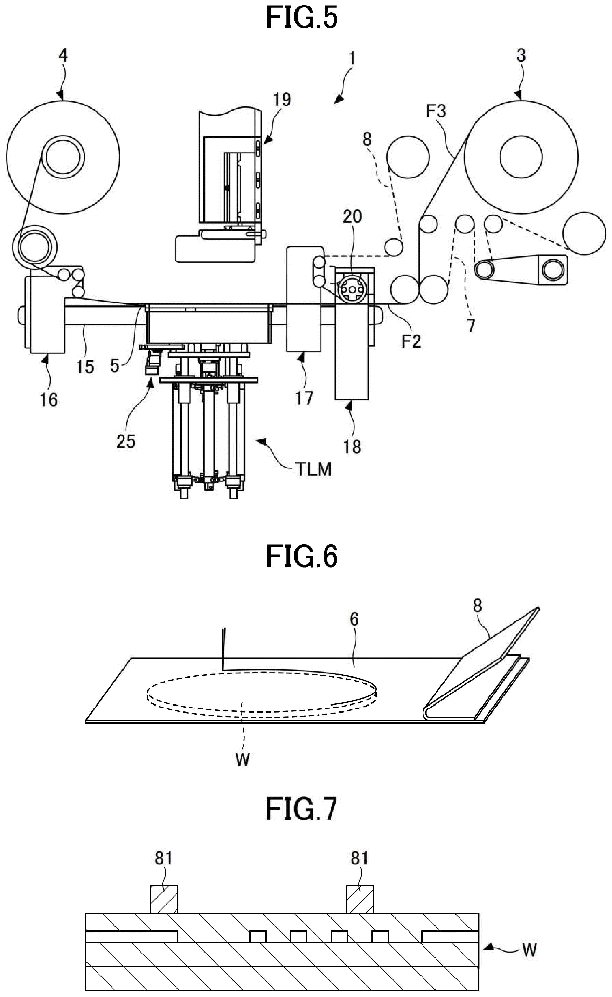

Next, as shown in FIG. 5, the film attaching device 1 moves back the second moving unit 17 and the third moving unit 18 to the original positions, thereby detaching the reinforcing film 8 from the two-layer film F2 on the semiconductor wafer W. As a result, only the photoresist film 6 remains on the surface of the semiconductor wafer W. Thereafter, the film attaching device 1 moves the cutting unit 19 horizontally along the outer peripheral edge of the semiconductor wafer W and irradiates the photoresist film 6 with a laser to trim (see FIG. 6). The remaining film, which is a portion of the photoresist film 6 other than a portion to be attached to the surface of the semiconductor wafer W, is detached by the first moving unit 16 functioning as a removing head and is wound onto the winding unit 4. As a result, the film attaching device 1 can obtain the semiconductor wafer W to which the photoresist film 6 is attached.

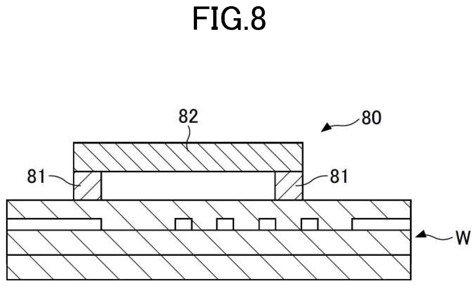

In the illustrated example, the photoresist film 6 attached to the surface of the semiconductor wafer W is then subjected to exposure processing, removal processing, and the like, and a pre-cured wall 81 is formed on the semiconductor wafer W as shown in FIG. 7. Next, a height level switching command corresponding to the semiconductor wafer W having the wall 81 is input to the controller 40, and the outer peripheral support member 5 is adjusted to the specific height level. A pressing pattern switching command corresponding to the semiconductor wafer W having the wall 81 is also input to the controller 40, and a specific pressing pattern is selected. Subsequently, the film attaching process as described above is performed again on the semiconductor wafer W having the wall 81, and the semiconductor wafer W having an additional photoresist film 6 attached on the wall 81 is obtained. Thereafter, the photoresist film 6 attached on the wall 81 is subjected to exposure processing, removal processing, and the like, and a hollow structure 80 including the wall 81 and a top portion 82 is formed on the semiconductor wafer W as shown in FIG. 8.

Note that, in the illustrated example, the height levels and the pressing patterns are different between the first film attaching processing and the second film attaching processing, but may be the same or only the height levels or the pressing patterns may be different.

The film attaching device 1 is configured to bring the pressing roller 20 into contact with the upper surface 5a of the outer peripheral support member 5 whose height level is adjusted, to press the photoresist film 6. Thus, the film attaching device 1 can minimize excessive pressing of the photoresist film 6 by the pressing roller 20 and attach the photoresist film 6 formed of a thin and soft material in a multilayer manner with minimum mechanical stress to the lower layers. In particular, when attaching the photoresist film 6 to be the wall 81 of the hollow structure 80, the film attaching device 1 can suitably absorb unevenness (surface pattern) on the surface of the semiconductor wafer W to minimize the mechanical stress on the semiconductor wafer W. Moreover, when attaching the photoresist film 6 to be the top portion 82 of the hollow structure 80, the film attaching device 1 can suitably absorb unevenness (surface pattern) on the surface of the pre-cured wall 81 to minimize the mechanical stress on the semiconductor wafer W and the wall 81.

The film attaching device 1 is configured to position the outer peripheral support member 5 at the specific height level by raising and lowering the outer peripheral support member 5 with the raising and lowering support mechanism 25 including the rotation motor 35. Therefore, the film attaching device 1 can stably attach a film to semiconductor wafers W of various shapes. As a result, the film attaching device 1 can form the hollow structure 80 having an ultrathin film thickness (e.g., about 50 µm) with excellent thickness accuracy on the semiconductor wafer W at a high yield. In particular, the film attaching device 1 can form the hollow structure 80 in a good condition on substantially the entire surface of the semiconductor wafer W. Moreover, the film attaching device 1 can form the hollow structure 80 having a larger film thickness (e.g., about 100 µm) by performing multilayer attaching of three or more photoresist films 6.

The film attaching device 1 is configured such that a pressing force of the pressing roller 20 can be adjusted by the pressing-force adjustment mechanism 21 including the pressing cylinder 22 and the like depending on a pressing area of the semiconductor wafer W. Therefore, the film attaching device 1 can stably attach a film to semiconductor wafers W of a wider variety of shapes.

The film attaching device 1 is also configured such that the height level storage 42 and the pressing pattern storage 43 are provided in the controller 40 to select a height level and a pressing pattern corresponding to the shape and the like of the semiconductor wafer W to be used, based on input information input to the controller 40. Therefore, the film attaching device 1 can stably attach a film to semiconductor wafers W of a wider variety of shapes.

Next, a configuration example of the raising and lowering support mechanism 25 configured to raise and lower the outer peripheral support member 5 will be described with reference to FIGS. 9 to 11. FIG. 9 is a view showing the configuration example of the raising and lowering support mechanism 25. Specifically, the upper part of FIG. 9 is a perspective view of the table 2, the outer peripheral support member 5, the pipes 13D, the raising and lowering support mechanism 25, and the table raising and lowering mechanism TLM. The lower part of FIG. 9 is a perspective view of the outer peripheral support member 5 and the raising and lowering support mechanism 25, corresponding to a view in which the table 2, the pipes 13D, and the table raising and lowering mechanism TLM are removed from the top part of FIG. 9. In the lower part of FIG. 9, for clarity, a side cover 5C, which is one of the components of the outer peripheral support member 5, is not shown.

In FIG. 9, X1 represents one direction of the X-axis in the three-dimensional Cartesian coordinate system, and X2 represents the other direction of the X-axis. Y1 represents one direction of the Y-axis in the three-dimensional Cartesian coordinate system, and Y2 represents the other direction of the Y-axis. Similarly, Z1 represents one direction of the Z-axis in the three-dimensional Cartesian coordinate system, and Z2 represents the other direction of the Z-axis. In FIG. 9, an X1 side of the outer peripheral support member 5 corresponds to a front side of the outer peripheral support member 5, and an X2 side of the outer peripheral support member 5 corresponds to a rear side of the outer peripheral support member 5. A Y1 side of the outer peripheral support member 5 corresponds to a left side of the outer peripheral support member 5, and a Y2 side of the outer peripheral support member 5 corresponds to a right side of the outer peripheral support member 5. A Z1 side of the outer peripheral support member 5 corresponds to an upper side of the outer peripheral support member 5, and a Z2 side of the outer peripheral support member 5 corresponds to a lower side of the outer peripheral support member 5. Similar definitions apply to other members in other drawings.

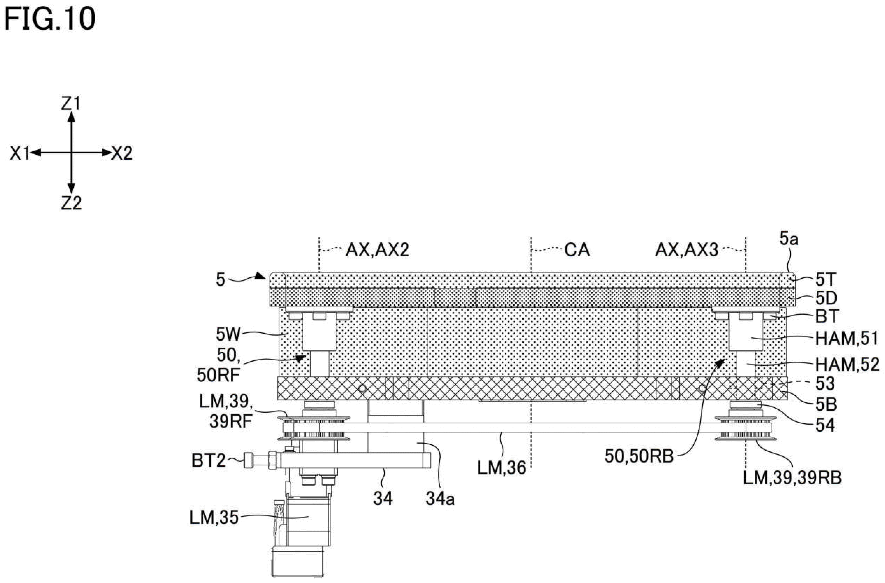

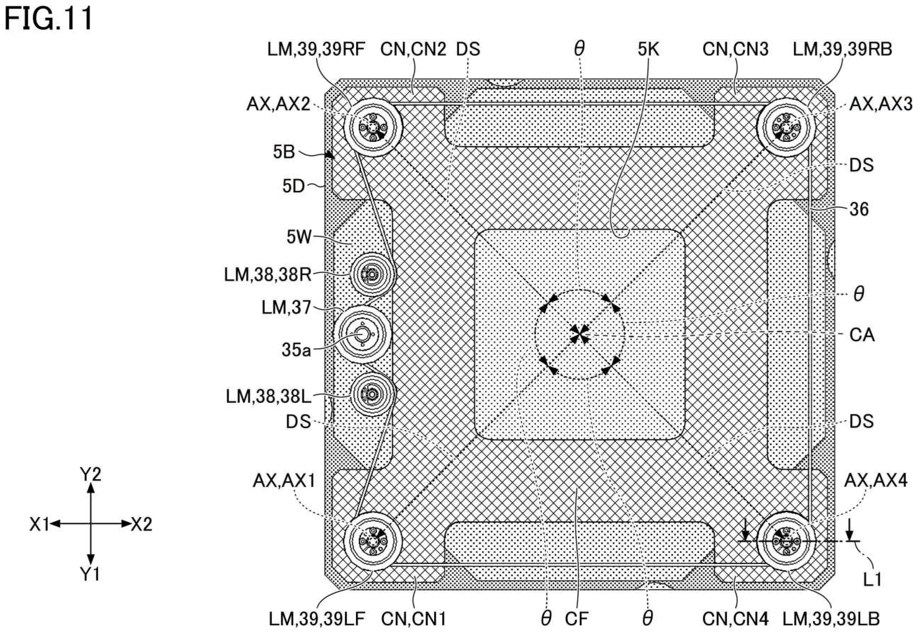

FIG. 10 is a right side view of the outer peripheral support member 5 and the raising and lowering support mechanism 25. In FIG. 10, for clarity, the side cover 5C is not shown, as in the lower part of FIG. 9. FIG. 11 is a bottom view of the outer peripheral support member 5 and the raising and lowering support mechanism 25. In FIG. 11, for clarity, some of the components of the raising and lowering support mechanism 25 (a mounting piece 34 and the rotation motor 35) and the side cover 5C are not shown.

In the illustrated example, the outer peripheral support member 5 includes a base plate 5B, the side cover 5C, a base 5D, a top plate 5T, and an outer peripheral wall 5W, as shown in FIG. 9. Note that, in FIGS. 10 and 11, for clarity, the base plate 5B is indicated by a cross pattern, the base 5D is indicated by a fine dotted pattern, and the top plate 5T and the outer peripheral wall 5W are indicated by a coarse dotted pattern. As shown in the lower part of FIG. 9, the raising and lowering support mechanism 25 includes a raising and lowering mechanism LM configured to raise and lower the outer peripheral support member 5, and a support mechanism 50 configured to support the outer peripheral support member 5.

Specifically, as shown in the lower part of FIG. 9, the raising and lowering mechanism LM includes the mounting piece 34, the rotation motor 35, a transmission belt 36, a drive pulley 37, a tension pulley 38, and a driven pulley 39. The driven pulley 39 includes a left-front driven pulley 39LF, a right-front driven pulley 39RF, a left-rear driven pulley 39LB (not visible in the lower part of FIG. 9), and a right-rear driven pulley 39RB. The tension pulley 38 includes a left tension pulley 38L arranged between the drive pulley 37 and the left-front driven pulley 39LF, and a right tension pulley 38R arranged between the drive pulley 37 and the right-front driven pulley 39RF.

The support mechanism 50 includes a left-front support mechanism 50LF, a right-front support mechanism 50RF, a left-rear support mechanism 50LB (not visible in the lower part of FIG. 9), and a right-rear support mechanism 50RB. In the illustrated example, the left-front support mechanism 50LF, the right-front support mechanism 50RF, the left-rear support mechanism 50LB, and the right-rear support mechanism 50RB have the same structure (the same shape and the same size). Specifically, as shown in FIG. 10, the support mechanism 50 includes a nut 51, a screw 52, a bearing 53, and a spacer 54.

The base plate 5B of the outer peripheral support member 5 is a member configured to support the base 5D, the top plate 5T, and the outer peripheral wall 5W via the support mechanism 50. In the illustrated example, the base plate 5B is fixed to the support 12 (see FIG. 1) of the table raising and lowering mechanism TLM, and is configured to be raised and lowered together with the support 12 by the table raising and lowering mechanism TLM. Specifically, as shown in FIG. 11, the base plate 5B is a metal plate having a substantially rectangular outer shape in plan view, including four corners CN (a first corner CN1 to a fourth corner CN4) and a central portion CF in which a rectangular opening 5K is formed.

The side cover 5C of the outer peripheral support member 5 is a portion that forms a side surface of the outer peripheral support member 5. In the illustrated example, the side cover 5C is mounted on the base plate 5B so as to cover the base plate 5B and the support mechanism 50, as shown in the upper part of FIG. 9.

The base 5D of the outer peripheral support member 5 is a portion that functions as a base for the top plate 5T of the outer peripheral support member 5, and is supported by the support mechanism 50 fixed to the base plate 5B. In the illustrated example, the base 5D is a metal plate having a substantially rectangular annular shape in plan view and having a circular opening for receiving the table 2.

The top plate 5T of the outer peripheral support member 5 is a portion fixed to an upper side of the base 5D. In the illustrated example, similar to the base 5D, the top plate 5T is a metal plate having a substantially rectangular annular shape in plan view and having a circular opening for receiving the table 2.

The outer peripheral wall 5W of the outer peripheral support member 5 is a portion that forms a portion of the exhaust passage 13. In the illustrated example, the outer peripheral wall 5W is a metal member having an open box shape with an octagonal bottom wall and an octagonal tubular sidewall in plan view. The octagonal tubular sidewall is connected to the four pipes 13D. Moreover, an upper end of the octagonal tubular sidewall is fixed to the base 5D.

As described above, the outer peripheral support member 5 is configured such that the base 5D, the top plate 5T, and the outer peripheral wall 5W can be raised and lowered with respect to the base plate 5B by the support mechanism 50. Specifically, as shown in FIG. 10, the bearing 53 of the support mechanism 50 is fixed to the base plate 5B. In the illustrated example, the bearing 53 is a ball bearing, and an inner ring thereof is fixed to the screw 52, and an outer ring thereof is fixed to the base plate 5B.

As shown in FIG. 10, the nut 51 of the support mechanism 50 is fixed to the base 5D by a bolt BT. In the illustrated example, the nut 51 is a trapezoidal screw nut, and forms a height adjustment mechanism HAM in cooperation with the trapezoidal screw 52. The height adjustment mechanism HAM is configured such that the nut 51 moves upward (Z1 direction) when the screw 52 is rotated in one direction about a rotation axis AX, and the nut 51 moves downward (Z2 direction) when the screw 52 is rotated in the other direction about the rotation axis AX.

In the illustrated example, as shown in the lower part of FIG. 9, the support mechanism 50 includes: the left-front support mechanism 50LF fixed to the first corner CN1 of the base plate 5B; the right-front support mechanism 50RF fixed to the second corner CN2 of the base plate 5B; the right-rear support mechanism 50RB fixed to the third corner CN3 of the base plate 5B; and the left-rear support mechanism 50LB (not visible in FIG. 9) fixed to the fourth corner CN4 (not visible in the lower part of FIG. 9, refer to FIG. 11) of the base plate 5B.

Specifically, as shown in FIG. 11, the left-front support mechanism 50LF is configured to rotate the screw 52 about a first rotation axis AX1, the right-front support mechanism 50RF is configured to rotate the screw 52 about a second rotation axis AX2, the right-rear support mechanism 50RB is configured to rotate the screw 52 about a third rotation axis AX3, and the left-rear support mechanism 50LB is configured to rotate the screw 52 about a fourth rotation axis AX4.

In the illustrated example, the first rotation axis AX1 to the fourth rotation axis AX4 are located such that distances DS from a central axis CA passing through the center of the table 2 are equal to each other, as shown in FIG. 11. Moreover, the first rotation axis AX1 to the fourth rotation axis AX4 are located such that angles (central angles) between line segments connecting the central axis CA and the first rotation axis AX1 to the fourth rotation axis AX4 are equal to each other, that is, an angle θ (90°).

An operator who adjusts the height of the outer peripheral support member 5 can independently adjust the height of each of the four corners 5N (the first corner 5N1 to the fourth corner 5N4) of the top plate 5T of the outer peripheral support member 5 as shown in the upper part of FIG. 9 by manually rotating the screw 52 of the height adjustment mechanism HAM in each of the left-front support mechanism 50LF, the right-front support mechanism 50RF, the left-rear support mechanism 50LB, and the right-rear support mechanism 50RB, for example.

The raising and lowering mechanism LM is configured to raise and lower the outer peripheral support member 5 by using the height adjustment mechanism HAM included in the support mechanism 50. Specifically, as described above, the raising and lowering mechanism LM includes the mounting piece 34, the rotation motor 35, the transmission belt 36, the drive pulley 37, the tension pulley 38, and the driven pulley 39. The driven pulley 39 includes the left-front driven pulley 39LF, the right-front driven pulley 39RF, the left-rear driven pulley 39LB, and the right-rear driven pulley 39RB. The left-front driven pulley 39LF, the right-front driven pulley 39RF, the left-rear driven pulley 39LB, and the right-rear driven pulley 39RB have the same structure (the same shape and the same size). The tension pulley 38 includes the left tension pulley 38L arranged between the drive pulleys 37 and the left-front driven pulley 39LF, and the right tension pulley 38R arranged between the drive pulley 37 and the right-front driven pulley 39RF. The left tension pulley 38L and the right tension pulley 38R have the same structure (the same shape and the same size).

In the illustrated example, the mounting piece 34 of the raising and lowering mechanism LM is a metal plate on which the rotation motor 35, the drive pulley 37, and the tension pulley 38 are mounted, and is fixed to the base plate 5B of the outer peripheral support member 5 via a bracket 34a (see FIG. 10). The rotation motor 35 is a drive configured to rotate the drive pulley 37, and is mounted to a lower surface of the mounting piece 34. The transmission belt 36 is a belt configured to transmit torque from the drive pulley 37 to the driven pulley 39. The drive pulley 37 is a member configured to rotate the driven pulley 39 via the transmission belt 36. The tension pulley 38 (the left tension pulley 38L and the right tension pulley 38R) is a member configured to adjust the tension of the transmission belt 36. The drive pulley 37, the left tension pulley 38L, and the right tension pulley 38R are mounted on an upper surface of the mounting piece 34. The driven pulley 39 is a member configured to transmit torque to the screw 52 of the support mechanism 50.

In the illustrated example, the driven pulley 39 includes: the left-front driven pulley 39LF fixed to the screw 52 of the left-front support mechanism 50LF: the right-front driven pulley 39RF fixed to the screw 52 of the right-front support mechanism 50RF; the left-rear driven pulley 39LB fixed to the screw 52 of the left-rear support mechanism 50LB; and the right-rear driven pulley 39RB fixed to the screw 52 of the right-rear support mechanism 50RB. Specifically, the left-rear driven pulley 39LB includes a fixed portion and a rotating portion configured to rotate with respect to the fixed portion. The fixed portion is fixed to a lower surface of the base plate 5B of the outer peripheral support member 5 with the spacer 54 interposed therebetween. The rotating portion is fixed to a lower end of the screw 52 so as to rotate integrally with the screw 52. Substantially the same configuration applies to the left-front driven pulley 39LF, the right-front driven pulley 39RF, and the right-rear driven pulley 39RB.

With such a configuration, the raising and lowering mechanism LM can simultaneously rotate the four driven pulleys 39 at the same rotation speed in the same direction by rotating the drive pulley 37 by the rotation motor 35. That is, the raising and lowering mechanism LM can simultaneously rotate the screw 52 of each of the four support mechanisms at the same rotation speed in the same direction. Accordingly, the raising and lowering mechanism LM can raise and lower the four corners 5N (the first corner 5N1 to the fourth corner 5N4) of the top plate 5T of the outer peripheral support member 5 at the same raising and lowering speed.

Note that the height adjustment of the first corner 5N1 using the left-front support mechanism 50LF is typically performed while the screws 52 of the three support mechanisms 50 other than the left-front support mechanism 50LF are not rotated. This is to prevent the heights of other corners 5N from being changed by the height adjustment of the first corner 5N1. Substantially the same configuration applies to the respective height adjustments using the right-front support mechanism 50RF, the left-rear support mechanism 50LB, and the right-rear support mechanism 50RB. Thus, in the illustrated example, the raising and lowering mechanism LM is configured to disengage the transmission belt 36 from the driven pulley 39. Specifically, the raising and lowering mechanism LM is configured to remove the transmission belt 36 from the driven pulley 39 by adjusting the position of the tension pulley 38 with position adjustment bolts BT2 (see the lower part of FIG. 9), that is, by loosening the tension of the transmission belt 36.

With this configuration, for example, when the height adjustment of the first corner 5N1 is performed using the left-front support mechanism 50LF, the operator can disengage the transmission belt 36 from the left-front driven pulley 39LF fixed to the screw 52 of the left-front support mechanism 50LF. Therefore, the operator can rotate only the screw 52 of the left-front support mechanism 50LF without rotating the screws 52 of other support mechanisms 50, and can adjust only the height of the first corner 5N1 without changing the heights of other corners 5N.

However, the driven pulley 39 may be configured to switch between a state where the screw 52 and the driven pulley 39 are integrally rotatable (a state where the screw 52 and the driven pulley 39 are relatively unrotatable) and a state where the screw 52 and the driven pulley 39 are relatively rotatable. In this case, the operator can rotate only the screw 52 of one support mechanism 50 without rotating the screws 52 of other three support mechanisms 50, without disengaging the transmission belt 36 from the driven pulley 39.

With the above-described configuration, the support mechanism 50 including the four height adjustment mechanisms HAM enables, for example, the operator to flexibly adjust the horizontality of the upper surface 5a of the outer peripheral support member 5. Since the rotation axis AX of the height adjustment mechanism HAM (screws 52) also functions as a support axis, the support mechanism 50 also enables the configuration to be simplified, as compared with a configuration in which a support axis is provided separately from the rotation axis of the height adjustment mechanism.

Since the nut 51 and the screw 52 that form the height adjustment mechanism HAM have relatively small diameters (e.g., 12 mm), the nut 51 and the screw 52 may be standard products (commercially available nuts and screws). Therefore, this configuration enables the height adjustment accuracy of the height adjustment mechanism HAM to be enhanced while minimizing an increase in the manufacturing cost of the support mechanism 50.

In the above-described embodiment, a combination of a trapezoidal screw nut and a trapezoidal screw is adopted as the height adjustment mechanism HAM, but a different mechanism such as a ball screw may be adopted.

With the above-described configuration, the raising and lowering mechanism LM enables, for example, the operator to raise and lower the outer peripheral support member 5 by using the support mechanism 50 including the four height adjustment mechanisms HAM.

In the above-described embodiment, the raising and lowering mechanism LM is configured to simultaneously operate the four height adjustment mechanisms HAM by using one rotation motor 35, but may be configured to independently operate the four height adjustment mechanisms HAM by using four rotation motors. In this case, the transmission belt 36, the drive pulley 37, the tension pulley 38, and the driven pulley 39 may be omitted.

In the above-described embodiment, the raising and lowering mechanism LM is configured to raise and lower the outer peripheral support member 5 by operating the height adjustment mechanism HAM using the driven pulley 39. Thus, this configuration enables the operator to easily change the raising and lowering increment of the outer peripheral support member 5. This is because this configuration enables the raising and lowering increment to be changed by changing the number of teeth of the driven pulley 39.

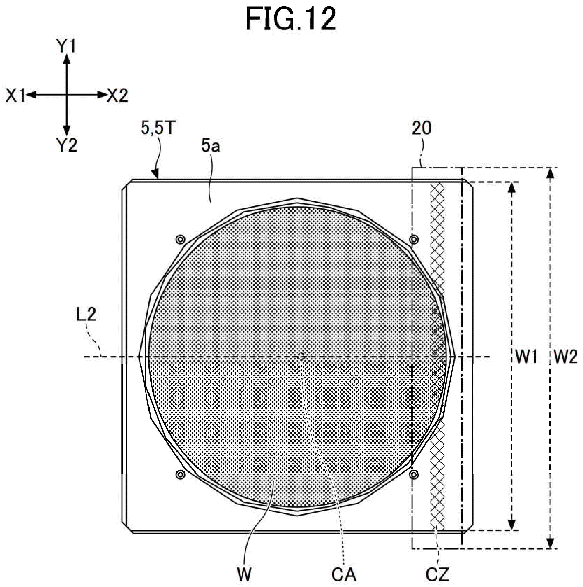

Next, an example of the shape and size of the top plate 5T of the outer peripheral support member 5 in plan view will be described with reference to FIG. 12. FIG. 12 is a top view of the semiconductor wafer W placed on the table 2 and the top plate 5T of the outer peripheral support member 5. Note that, in FIG. 12, for clarity, the upper surface of the semiconductor wafer W is indicated by a dotted pattern. In FIG. 12, the size of the pressing roller 20 in plan view is indicated by a dash-dot line, and a region CZ (contact area) where the pressing roller 20 is in contact with the semiconductor wafer W and the top plate 5T is indicated by a cross pattern. In the illustrated example, the pressing roller 20 is configured to move in the X-axis direction while rolling.

In the illustrated example, the top plate 5T has a substantially rectangular outer shape in plan view, and is configured such that a width W1 in a direction along the rotation axis of the pressing roller 20 (Y-axis direction) is shorter than a width W2 of the pressing roller 20. However, the width W1 of the top plate 5T may be longer than the width W2 of the pressing roller 20, or may be the same as the width W2 of the pressing roller 20.

This configuration enables a total contact area, which is the sum of a contact area (first contact area) between the semiconductor wafer W and the pressing roller 20 and a contact area (second contact area) between the top plate 5T and the pressing roller 20, to be made constant regardless of the position of the pressing roller 20 in the X-axis direction. This means that, if the pressing force applied by the pressing roller 20 is constant, the pressing force per unit contact area in the first contact area can be made constant regardless of the position of the pressing roller 20 in the X-axis direction. Therefore, this configuration enables a film such as the photoresist film 6 to be uniformly attached to the semiconductor wafer W placed on the table 2.

In the illustrated example, the top plate 5T has a shape that is linesymmetric with respect to a broken line L2 parallel to the X-axis passing through the central axis CA. This configuration enables the size of a portion of the first contact area (first left contact area) at one side (Y1 side, left side) of the second contact area and the size of the remaining portion of the first contact area (first right contact area) on the other side (Y2 side, right side) of the second contact area to be made the same regardless of the position of the pressing roller 20 in the X-axis direction. This means that variations in the pressing force applied by the pressing roller 20 in the Y-axis direction can be minimized. Therefore, this configuration enables a film such as the photoresist film 6 to be uniformly attached to the semiconductor wafer W placed on the table 2.

Moreover, since the top plate 5T has a substantially rectangular outer shape in plan view, the film attaching device 1 enables the size of the upper surface 5a of the top plate 5T to be reduced while realizing four-point support by the support mechanism 50, as compared with a case where the top plate has a circular outer shape in plan view. However, the top plate 5T may have an outer shape other than the substantially rectangular shape in plan view (e.g., an outer shape such as a circular shape, a hexagonal shape, or an octagonal shape).

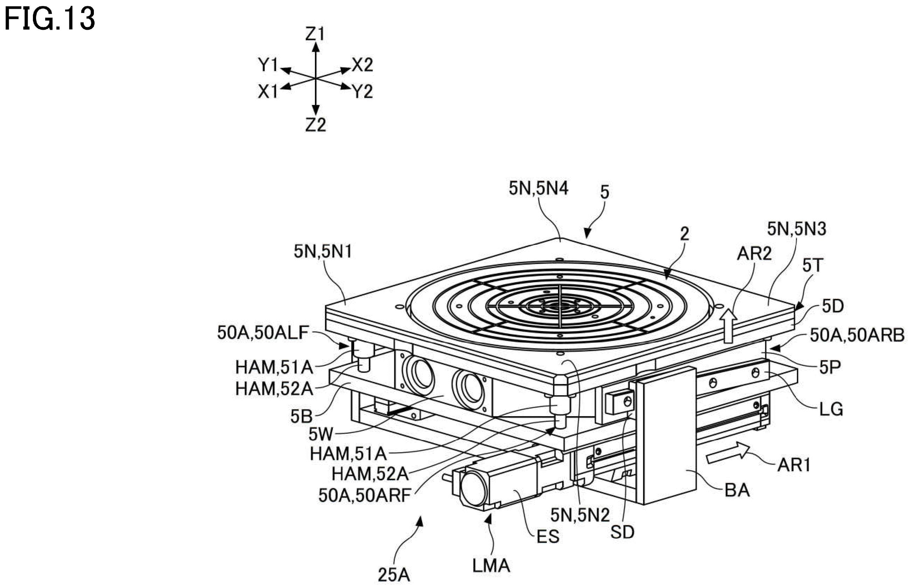

Next, a raising and lowering support mechanism 25A, which is another configuration example of the raising and lowering support mechanism 25 that raises and lowers the outer peripheral support member 5, will be described with reference to FIG. 13. FIG. 13 is a view showing the configuration example of the raising and lowering support mechanism 25A. Specifically, FIG. 13 is a perspective view of the table 2, the outer peripheral support member 5, and the raising and lowering support mechanism 25A.

Similar to the raising and lowering support mechanism 25, the raising and lowering support mechanism 25A includes a raising and lowering mechanism LMA configured to raise and lower the outer peripheral support member 5, and a support mechanism 50A configured to support the outer peripheral support member 5 at four points.

The support mechanism 50A differs from the support mechanism 50 in that the support mechanism 50A includes a height adjustment mechanism HAM composed of a linear bushing 51A and a linear shaft 52A, whereas the support mechanism 50 includes the height adjustment mechanism HAM composed of the nut 51 and the screw 52. The linear bushing 51A is a rolling-guide linear motion mechanism, and is configured such that relative movement between the linear bushing 51A and the linear shaft 52A is locked by a lock lever (not shown). In the illustrated example, the support mechanism 50A includes: a left-front support mechanism 50ALF configured to adjust the height of the first corner 5N1; a right-front support mechanism 50ARF configured to adjust the height of the second corner 5N2; a right-rear support mechanism 50ARB configured to adjust the height of the third corner 5N3; and a left-rear support mechanism 50ALB configured to adjust the height of the fourth corner 5N4 (not visible in FIG. 13).

With this support mechanism 50A, an operator who adjusts the height of the outer peripheral support member 5 can independently adjust the height of each of the four corners 5N (the first corner 5N1 to the fourth corner 5N4) of the top plate 5T of the outer peripheral support member 5 by manually moving the linear bushing 51A vertically along the linear shaft 52A in each of the height adjustment mechanism HAM in the left-front support mechanism 50ALF, the right-front support mechanism 50ARF, the left-rear support mechanism 50ALB, and the right-rear support mechanism 50ARB, for example. In the illustrated example, the height of the corner 5N is the height from the upper surface of the base plate 5B.

The raising and lowering mechanism LMA differs from the raising and lowering mechanism LM in that the raising and lowering mechanism LMA uses an electric slider ES, whereas the raising and lowering mechanism LM uses the rotation motor 35. In the illustrated example, the electric slider ES is configured to move a bracket arm BA along the X-axis direction by using a stepping motor and a ball screw mechanism. A coupling plate 5P is fixed to the base plate 5B of the outer peripheral support member 5, and a linear guide LG is fixed to a side surface of the coupling plate 5P at a predetermined inclination (e.g., a gradient of 1/20). A slider SD is fixed to the upper end of the bracket arm BA so as to be slidable along the linear guide LG.

With such a configuration, the raising and lowering mechanism LMA can move the outer peripheral support member 5 including the base plate 5B in a direction indicated by an arrow AR2 (upward, Z1 direction) by moving the bracket arm BA in a direction indicated by an arrow AR1 (rearward, X2 direction) with the electric slider ES. Substantially the same configuration applies to a case where the outer peripheral support member 5 including the base plate 5B is moved in the opposite direction (downward, Z2).

That is, the raising and lowering mechanism LMA can move, in the Z-axis direction, the base plate 5B and the coupling plate 5P to which the linear guide LG is fixed, by moving the bracket arm BA in the X-axis direction with the electric slider ES. Thus, the raising and lowering mechanism LMA can move, in the Z-axis direction, the base 5D, the outer peripheral wall 5W, and the top plate 5T fixed to the base plate 5B via the support mechanism 50A. Therefore, the raising and lowering mechanism LMA can raise and lower the four corners 5N (the first corner 5N1 to the fourth corner 5N4) of the top plate 5T at the same raising and lowering speed.

With the above-described configuration, the film attaching device 1 including the raising and lowering support mechanism 25A can achieve the same effects as the film attaching device 1 including the raising and lowering support mechanism 25. Specifically, the film attaching device 1 including the raising and lowering support mechanism 25A enables the operator to flexibly adjust the horizontality of the upper surface 5a of the outer peripheral support member 5. The film attaching device 1 including the raising and lowering support mechanism 25A can also raise and lower the four corners 5N (the first corner 5N1 to the fourth corner 5N4) of the top plate 5T of the outer peripheral support member 5 at the same raising and lowering speed.

As described above, as shown in FIG. 1, the semiconductor manufacturing device (the film attaching device 1) according to an embodiment of the present disclosure includes: the table 2 configured to support the semiconductor wafer W; the pressing member (the pressing roller 20) configured to press a film (the photoresist film 6) to be attached to the semiconductor wafer W placed on the table 2; the outer peripheral support member 5 provided on an outer peripheral side of the table 2 and arranged so as to receive a pressing force from the pressing member (the pressing roller 20) when the pressing member (the pressing roller 20) presses the film (the photoresist film 6); and the support mechanism 50 configured to support the outer peripheral support member 5 at at least three positions spaced apart from each other in plan view and independently adjust a height of the outer peripheral support member 5 at the at least three positions. In the example shown in FIG. 1, the support mechanism 50 includes the left-front support mechanism 50LF, the right-front support mechanism 50RF, the left-rear support mechanism 50LB, and the right-rear support mechanism 50RB. Each of the left-front support mechanism 50LF, the right-front support mechanism 50RF, the left-rear support mechanism 50LB, and the right-rear support mechanism 50RB has the height adjustment mechanism HAM. In the illustrated example, the semiconductor manufacturing device is the film attaching device 1, which is an example of a laminator, but may be a mounter that attaches a film to a ring. That is, the outer peripheral support member 5 supported by the support mechanism 50 may be mounted on a mounter as a member on which the ring is placed. The same applies to features described below. That is, the features described below may be mounted in the mounter.

With this configuration, the semiconductor manufacturing device is capable of correcting the inclination of the upper surface of the outer peripheral support member 5. Specifically, the semiconductor manufacturing device enables the operator to adjust the horizontality of the upper surface 5a of the outer peripheral support member 5.

The semiconductor manufacturing device (the film attaching device 1) may include the raising and lowering mechanism LM configured to raise and lower the outer peripheral support member 5. In the illustrated example, the raising and lowering mechanism LM includes the rotation motor 35, the transmission belt 36, the drive pulley 37, the tension pulley 38, and the driven pulley 39, as shown in FIGS. 10 and 11. However, the raising and lowering mechanism LM may include other mechanical elements such as a gear, a chain, or a wire. The raising and lowering mechanism LM may be omitted. Even in this case, the operator can adjust the horizontality of the upper surface 5a of the outer peripheral support member 5 by using the height adjustment mechanism HAM in each of the left-front support mechanism 50LF, the right-front support mechanism 50RF, the left-rear support mechanism 50LB, and the right-rear support mechanism 50RB. The operator can also make the semiconductor wafer W placed on the upper surface of the table 2 and the upper surface 5a of the outer peripheral support member 5 flush with each other by raising and lowering the table 2.

As shown in FIG. 9, the outer peripheral support member 5 may have a substantially rectangular outer shape in plan view and may be arranged so as to surround the table 2. In this case, the height adjustment mechanism HAM may be configured to independently adjust the height of each of the four corners of the outer peripheral support member 5.

With this configuration, the semiconductor manufacturing device is capable of correcting the inclination of the upper surface of the outer peripheral support member 5 even when the outer peripheral support member 5 is supported at four points by the support mechanism 50, for example.

The raising and lowering mechanism LM may be configured to simultaneously raise and lower the four corners of the outer peripheral support member 5. In the illustrated example, the raising and lowering mechanism LM is configured to raise and lower the outer peripheral support member 5 by simultaneously operating the height adjustment mechanism HAM in each of the left-front support mechanism 50LF, the right-front support mechanism 50RF, the left-rear support mechanism 50LB, and the right-rear support mechanism 50RB.

With this configuration, the semiconductor manufacturing device is capable of raising and lowering the outer peripheral support member 5 with the inclination of the upper surface of the outer peripheral support member 5 corrected. Specifically, the semiconductor manufacturing device enables the operator to raise and lower the outer peripheral support member 5 while the horizontality of the upper surface 5a of the outer peripheral support member 5 is maintained.

The preferred embodiments of the present invention have been described in detail above. However, the present invention is not limited to the above-described embodiments. Various modifications, substitutions, and the like can be applied to the above-described embodiment without departing from the scope of the present invention. The features described with reference to the above-described embodiments may be combined as appropriate without technical inconsistency.

This application claims priority based on Japanese Patent Application No. 2023-141612 filed on August 31, 2023, the entire contents of which are incorporated herein by reference.

**Reference Sign List**

| | | | |
|---|---|---|---|
| 1 | Film attaching device | 2 | Table |
| 2G | Groove | 3 | Film supply unit |
| 4 | Winding unit | 5 | Outer peripheral support member |
| 5a | Upper surface | 5B | Base plate |
| 5C | Side cover | 5D | Base |
| 5K | Opening | 5N | Corner |
| 5N1 | First corner | 5N2 | Second corner |
| 5N3 | Third corner | 5N4 | Fourth corner |
| 5P | Coupling plate | 5T | Top plate |
| 5W | Outer peripheral wall | 6 | Photoresist film |
| 7 | Carrier film | 8 | Reinforcing film |
| 9 | Pinch roller | 10 | Slide rod |
| 11 | Base plate | 12 | Support |
| 13 | Exhaust passage | 13D | Pipe |
| 13G | Gap | 15 | Slide shaft |
| 16 | First moving unit | 17 | Second moving unit |
| 18 | Third moving unit | 19 | Cutting unit |
| 20 | Pressing roller | 21 | Pressing-force adjustment mechanism |
| 22 | Pressing cylinder | 22a | Piston rod |
| 25, 25A | Raising and lowering support mechanism | | |
| 34 | Mounting piece | 34a | Bracket |
| 35 | Rotation motor | 36 | Transmission belt |
| 37 | Drive pulley | 38 | Tension pulley |
| 38L | Left tension pulley | 38R | Right tension pulley |
| 39 | Driven pulley | 39LB | Left-rear driven pulley |
| 39LF | Left-front driven pulley | 39RB | Right-rear driven pulley |
| 39RF | Right-front driven pulley | 40 | Controller |
| 41 | Input device | 42 | Height level storage |
| 43 | Pressing pattern storage | 50, 50A | Support mechanism |
| 50LB, 50ALB | Left-rear support mechanism | | |
| 50LF, 50ALF | Left-front support mechanism | | |
| 50RB, 50ARB | Right-rear support mechanism | | |
| 50RF, 50ARF | Right-front supportmechanism | | |
| 51 | Nut | 51A | Linear bushing |
| 52 | Screw | 52A | Linear shaft |
| 53 | Bearing | 54 | Spacer |
| 80 | Hollow structure | 81 | Wall |
| 82 | Top portion | AX | Rotation axis |
| AX1 | First rotation axis | AX2 | Second rotation axis |
| AX3 | Third rotation axis | AX4 | Fourth rotation axis |
| BA | Bracket arm | BT | Bolt |
| BT2 | Position adjustment bolt | CA | Central axis |
| CF | Central portion | CN | Corner |
| CN1 | First corner | CN2 | Second corner |
| CN3 | Third corner | CN4 | Fourth corner |
| CZ | Region | F2 | Two-layer film |
| ES | Electric slider | F3 | Three-layer film |
| HAM | Height adjustment mechanism | LG | Linear guide |
| LM, LMA | Raising and lowering mec hanism | | |
| SD | Slider | TLM | Table raising and lowering mechanism |
| W | Semiconductor wafer | | |

## Claims

1. A semiconductor manufacturing device, comprising:
a table configured to support a semiconductor wafer;
a pressing member configured to press a film to be attached to the semiconductor wafer placed on the table;
an outer peripheral support member provided on an outer peripheral side of the table and arranged so as to receive a pressing force from the pressing member when the pressing member presses the film; and
a support mechanism configured to support the outer peripheral support member at at least three positions spaced apart from each other and independently adjust a height of the outer peripheral support member at the at least three positions.

2. The semiconductor manufacturing device according to claim 1, further comprising:
a raising and lowering mechanism configured to raise and lower the outer peripheral support member.

3. The semiconductor manufacturing device according to claim 2, wherein
the outer peripheral support member has a substantially rectangular outer shape in plan view and is arranged so as to surround the table,
the support mechanism includes a height adjustment mechanism, and
the height adjustment mechanism is configured to independently adjust a height of the outer peripheral support member at each of four corners of the outer peripheral support member.

4. The semiconductor manufacturing device according to claim 3, wherein
the raising and lowering mechanism is configured to simultaneously raise and lower each of the four corners of the outer peripheral support member.

5. A support mechanism mounted on a semiconductor manufacturing device, wherein
the semiconductor manufacturing device includes:
a table configured to support a semiconductor wafer;
a pressing member configured to press a film to be attached to the semiconductor wafer placed on the table; and
an outer peripheral support member provided on an outer peripheral side of the table and arranged so as to receive a pressing force from the pressing member when the pressing member presses the film, and
the support mechanism is configured to support the outer peripheral support member at at least three positions spaced apart from each other and independently adjust a height of the outer peripheral support member at the at least three positions.
